# EUROPÄISCHE PATENTSCHRIFT

(11) **EP 0 801 814 B1**
(45) Veröffentlichungstag und Bekanntmachung des Hinweises auf die Patenterteilung: **29.08.2001**
(21) Anmeldenummer: 95943224.6
(22) Anmeldetag: 29.12.1995
(51) Int. Cl.: H01L 21/00

(54) **ANLAGE ZUR CHEMISCHEN NASSBEHANDLUNG**
WET CHEMICAL TREATMENT INSTALLATION
INSTALLATION DE TRAITEMENT CHIMIQUE PAR VOIE HUMIDE

(30) Priorität: 05.01.1995 DE 19500239; 15.12.1995 DE 19546990
(43) Veröffentlichungstag der Anmeldung: 22.10.1997
(73) Patentinhaber: STEAG MicroTech GmbH, 72124 Pliezhausen (DE)
(72) Erfinder: DURST, Johann, D-72124 Pliezhausen (DE); SIGEL, Holger, D-72124 Pliezhausen (DE); SCHULZ, Werner, D-73434 Aalen (DE)
(74) Vertreter: Wagner, Karl H., Dipl.-Ing.
(86) Internationale Anmeldenummer: EP9505153
(87) Internationale Veröffentlichungsnummer: WO9621241

(56) Entgegenhaltungen:
- EP-A- 0 523 836
- FR-A- 2 586 658
- GB-A- 2 178 594
- US-A- 4 722 752
- US-A- 5 301 700

## Beschreibung

Die vorliegende Erfindung betrifft eine Anlage zur chemischen Naßbehandlung von Substraten in einem ein Behandlungsfluid enthaltenden Behälter, mit einer Aushubvorrichtung zum Ein- und Ausbringen wenigstens eines Substratträgers und der Substrate, sowie ein Trocknungsverfahren unter Verwendung einer derartigen Aushubvorrichtung.

Heutzutage weist eine automatische Naßbank eine Reihe von Becken oder Tanks für eine Abfolge chemischer Naßprozesse auf. Nach Abschluß einer chemischen Prozeßfölge oder zwischen Prozeßschritten werden Substrate, zum Beispiel in einer Kassette angeordnete Siliziumwafer, in ein Spülbecken getaucht und anschließend getrocknet.

Das Trocknen eines Substrats kann beispielsweise mittels einer Zentrifuge erfolgen, aber auch während des langsamen Herausfahrens des Substrats aus dem Spülbecken.

Aus der EP 0 385 536 ist ein Trocknungsverfahren bekannt, bei dem zusätzlich zum langsamen Herausfahren des Substrats aus einem Bad ein Dampf auf das Substrat angewendet wird, wobei der Dampf nicht auf dem Substrat kondensiert, jedoch in die Flüssigkeit diffundiert. Am Flüssigkeits-Meniskus auf der Substratoberfläche entsteht ein Konzentrationsgradient und damit ein Oberflächenspannungsgradient, der eine Flüssigkeitsbewegung vom Substrat weg in die Flüssigkeit erzeugt und ein rückstandsfreies Trocknen des Substrats bewirkt. Während der chemischen Naßbehandlung bzw. des Spülens und des Trocknens werden die Substrate in Trägern, auch Waferkassetten genannt, in Schlitzen, die auf der Innenfläche der Seitenwände der Kassette ausgebildet sind, gehalten. Derartige Standardträger weisen insbesondere auch relativ große Flächen mit Kanten und Ecken auf, so daß eine relativ große Menge an Chemikalien von einem Prozeßtank in einen anderen bzw. von einem Bad in ein anderes Bad, verschleppt und der Trockungsvorgang erschwert wird. Die Kanten und großen Flächen der herkömmlichen Substratträger verlängern insbesondere auch die jeweiligen Reinigungs-, Spül- und Trocknungsschritte während der Behandlung, weil relativ viel Flüssigkeit an den Flächen, Kanten und Ecken haften bleibt, und das Freispülen der Chemikalien umständlicher wird. Wenn der Träger jedoch keine seitlichen Führungen aufweist, fehlen auch seitliche Führungen für die Substrate während des Aushubs. Bei den bekannten Vorrichtungen werden die seitlichen Trägerführungen dazu benutzt, die Substrate während des Herausfahrens aus einem Bad zu halten, um die Substrate beim Ausheben aus dem Träger vor dem Umfallen zu schützen.

Aus der JP 5-27 06 60 (A) ist eine Vorrichtung der eingangs genannten Art bekannt, bei der eine Aushubvorrichtung mit einem Transportschlitten zum Ein- und Ausbringen von Substraten und Substratträger in und aus einem Behälter zur chemischen Naßbehandlung vorgesehen ist. Wie im Falle des Aus- und Einbringens bei der aus der EP 0 385 536 A bekannten Anordnung bleiben die Substrate im Träger, der zusammen mit dem Träger ein- und ausgebracht wird.

Aus der US 52 99 901 ist ein Substrat-Handhabungsgerät bekannt, bei der ein erster Transportschlitten einen Träger für die Substrate und ein zweiter Transportschlitten die Substrate in und aus dem Träger bewegt. Das Ein- und Ausbringen von Substraten bzw. Substratträgern aus einem Behälter für chemische Naßbehandlung von Substraten und die damit verbundenen Erfordernisse und Schwierigkeiten sind in dieser Druckschrift nicht angesprochen.

Aus der US 49 63 069 ist eine Substrat-Handhabungsvorrichtung bekannt, bei der ein Substrat-Träger mittels einer Hubvorrichtung auf und nieder bewegt wird und zusätzlich eine Kolben-Zylindereinheit mit einer Gelenkverbindung zur Hubstange vorgesehen ist, um den Substrat-träger aus der Hubbewegung heraus zu bewegen.

Aus der DE 34 25 267 C2 ist eine Vorrichtung zum Transportieren und individuellen Behandeln von Substraten bekannt, bei der die Substrate innerhalb des Substratträgers und aus diesem heraus angehoben werden.

Die US 34 93 093 zeigt und beschreibt eine Transport- und Handhabungsvorrichtung, mit der Gegenstände angehoben bzw. transportiert werden, bei der eine Steuerkurve eingesetzt wird.

Aus der US 4 722 752 ist eine Vorrichtung und ein Verfahren zum Spülen und Trocknen von Wafern bekannt, mit einer Aushubvorrichtung zum Ein- und Ausbringen wenigstens eines Waferträgers und der Wafer, wobei die Aushubvorrichtung einen ersten Transportschlitten für eine Waferanhebevorrichtung und einen zweiten Transportschlitten für einen Waferträger-Halter aufweist.

Der Erfindung liegt die Aufgabe zugrunde, eine Anlage bzw. ein Verfahren für die chemische Naßbehandlung, insbesondere für eine Spülung und/oder Trocknung zu schaffen bzw. anzugeben, bei der bzw. bei dem ein kontinuierliches und sicheres Aus- bzw. Einheben der Substrate möglich ist.

Die gestellte Aufgabe wird erfindungsgemäß dadurch gelöst, daß die Aushubvorrichtung einen ersten Transportschlitten für die Substrate und einen zweiten Transportschlitten für den Substratträger aufweist, die über eine Gelenkverbindung untereinander verbunden sind. Dadurch ist eine getrennte Aushubsteuerung für die Substrate und den Substratträger und damit eine optimale Anpassung der Bewegungen an die Prozeßerfordernisse möglich. Eine derartige Verbindung mit der Möglichkeit einer Relativbewegung der Schlitten zueinander führt zu einer optimalen Anpassung der Bewegungen der beiden Schlitten und damit der Substrate und des Substratträgers. Die erfindungsgemäßen Merkmale und Maßnahmen ermöglichen das kontinuierliche Herausfahren der Träger mit den darin enthaltenen Substraten und das nachfolgende Herausheben der Substrate aus dem Träger, ohne daß während dieses gesamten Vorgangs ein Stillstand oder ein starkes Vermindern der Geschwindigkeit der herauszufahrenden Träger insbesondere auch während des Wechsels von der Bewegung des Trägers zur Bewegung der Substrate relativ zum Träger eintritt. Bei der Behandlung von Trägern, insbesondere von Wafern ist es nämlich sehr wichtig, daß ein Stillstand während des Aushebens der Wafer aus dem Behandlungs-, Spül- oder Reinigungsbad nicht auftritt, weil andernfalls bei Unterbrechen des Bewegungsvorgangs sich im Bereich des Übergangs aus der Flüssigkeit in den Raum oberhalb der Flüssigkeitsoberfläche Partikel auf dem Wafer absetzen. Durch den mit den erfindungsgemäßen Maßnahmen möglichen Differentialhub zwischen Träger und Substraten ist eine stetige, kontinuierliche Bewegung der Substrate aus der Flüssigkeit heraus und insbesondere durch die Flüssigkeitsoberfläche hinweg möglich.

Vorteilhafte Ausführungsformen der Erfindung sind in den Unteransprüchen angegeben.

Vorzugsweise ist der erste Transportschlitten mit einer Antriebsvorrichtung verbunden. Der zweite Transportschlitten wird dabei nicht selbstständig sondern nur über den ersten Transportschlitten angetrieben.

Gemäß einer weiteren vorteilhaften Ausführungsform der Erfindung weist die Gelenkverbindung zwei Schenkel auf, wobei ein erster Schenkel mit dem ersten Transportschlitten und ein zweiter Schenkel mit dem zweiten Transportschlitten gelenkig verbunden ist. Die den Transportschlitten abgewandten Enden der Schenkel sind über ein Stift drehbar verbunden.

Vorteilhafterweise läuft ein vorstehender Bereich des die beiden Schenkel verbindenden Stifts an einer Steuerkurve ab. Die Steuerkurve gibt dadurch den Bewegungsablauf des Verbindungspunkts der beiden Schenkel vor. Durch eine geeignete Wahl der Steuerkurve kann auf die Bewegung der ersten und zweiten Transportschlitten zusammen, aber auch unabhängig voneinander Einfluß genommen werden. Dadurch wird ein Differenzhub realisiert, der anfänglich die Substratträger und die Substrate gemeinsam in gleicher Geschwindigkeit bewegt und dann die Bewegung des Substratträgers anhält, während sich die Substrate weiter bewegen. Durch die Verbindung eines Substratträgers ohne seitliche Führungen, die auch unter der Bezeichnung "Low Mass Carrier" oder "Low Profile Carrier" bekannt sind, mit einem derartigen Differenzhubmechanismus entfallen fest installierte Substratträgeraufnahmen im Behälter, die für das Prozessieren von Standardcarriern erforderlich sind.

Vorteilhafterweise weist die Steuerkurve einen geraden, parallel zur Bewegungsrichtung verlaufenden Abschnitt und einen sich an den geraden Abschnitt anschließenden Kurvenabschnitt auf; es vergrößert sich der Abstand zwischen dem ersten und zweiten Transportschlitten, und damit zwischen den Substraten und dem Substratträger, wenn der Stift auf dem Kurvenabschnitt abläuft. Durch die Vergrößerung des Abstands zwischen den Substraten und den Substratträgern werden die Substrate aus dem Substratträger gehoben.

Vorteilhafterweise ist die Form des Kurvenabschnitts so gewählt, daß sich der Abstand zwischen dem ersten und zweiten Transportschlitten stetig vergrößert. Dadurch ist eine konstante Aushubgeschwindigkeit der Substrate sichergestellt, so daß Trocknungsflecken und Partikelanhäufungen an den Substraten aufgrund ruckartiger Bewegungen oder gar Stillstand sicher vermieden werden.

Vorzugsweise ist die Form des Kurvenabschnitts in seinem Endbereich so gewählt, daß der zweite Transportschlitten allmählich zum Stillstand kommt. Der Punkt, an dem der zweite Transportschlitten zum Stillstand kommt, ist so gewählt, daß der zweite Transportschlitten vorzugsweise dann zum Stillstand kommt, wenn die Substrate mit einer Führung außerhalb des Substratträgers in Eingriff kommen, der Substratträger jedoch noch nicht mit den außerhalb des Beckens vorgesehenen Substratführungen kollidiert.

Vorteilhafterweise ist der erste Transportschlitten mit einer messerartigen Anhebevorrichtung, auch "Messer" genannt, verbunden, der bzw. das die Substrate an einem Punkt unterstützt, so daß nur ein punktförmiger Kontakt stattfindet. Dieser Kontakt des Substrats verläßt das Fluid zuletzt beim Herausfahren. Die Messerform hat den Vorteil, daß an dieser Stelle auf den Substraten befindliches Fluid durch die messerartige bzw. spitze Form abgeleitet wird. Das "Messer" ist mit Einkerbungen versehen, die die Substrate vor dem Verrutschen schützen.

Es werden die messerartige Anhebevorrichtung und der Substratträger mit gleicher Geschwindigkeit angehoben, wenn der Stift aus dem geraden Abschnitt der Steuerkurve abläuft. Dies ist dann der Fall, wenn sich die Substrate während des Anhebens noch im Substratträger befinden. Der zweite Transportschlitten kommt erst dann zum Stillstand, wenn die Substrate in Führungen außerhalb des Substratträgers in Eingriff kommen.

Falls eine Haube über dem Behälter angeordnet ist, insbesondere bei einem Trocknungsvorgang, ist es besonders vorteilhaft, wenn die Führungen innen an den Seitenwänden der Haube ausgebildet sind. Die Haube, die primär zur Abdeckung des Behälters bzw. des Beckens vorgesehen ist, dient somit auch zur Führung der Substrate, wenn diese nicht in Eingriff mit dem Substratträger stehen. Vorteilhafterweise ist an der Deckwand der Haube eine Diffusorplatte angeordnet, um eine Isopropylalkohol (IPA)/N₂-Atmosphäre zur Verbesserung des Trocknungsvorgangs zu erzeugen.

Vorteilhafterweise weist die erfindungsgemäße Aushubvorrichtung zusätzlich einen lös- und arretierbaren Klinkmechanismus auf, der den ersten und zweiten Transportschlitten starr miteinander verbindet. Die starre Verbindung zwischen dem ersten und zweiten Transportschlitten, entspricht der Bewegung des Stifts der Gelenkverbindung auf dem parallel zur Bewegungsrichtung verlaufenden Abschnitt der Steuerkurve. Bei verriegeltem Klinkmechanismus ist der Substratträger mit den Substraten vollständig aus dem Behälter aushebbar, beispielsweise dann, wenn sich die Übergabeposition des Substratträgers im oberen Beckenbereich befindet, und insbesondere wenn der Substratträger mit den Substraten in das Becken ein- oder aus dem Becken ausgebracht werden soll. Vorzugsweise ist ein Zylinder vorgesehen, der den Klinkmechanismus für eine einfache Steuerung ent- und/oder verriegelt, insbesondere bei Verwendung der Anlage als Modul eines automatisch zu beladenden Systems. Durch den lösbaren Klinkmechanismus wird gewährleistet, daß die Transportschlitten gemeinsam zum Be- bzw. Entladen in die obere Position fahren können, jedoch auch zum Ausheben der Substrate aus dem Substratträger getrennt werden können.

Der vorliegenden Erfindung liegt weiterhin die Aufgabe zugrunde, die Ausbeute bei der Herstellung von Halbleiterchips und/oder Wafern bzw. mit den zuvor beschriebenen Vorrichtungen weiter zu erhöhen, den Verfahrensablauf weiter zu vereinfachen, und die Fertigungsqualität zu verbessern.

Diese Aufgabe wird im Zusammenhang mit den zuvor genannten Vorrichtungen oder Anlagen erfindungsgemäß dadurch gelöst, daß eine verschiebbare Haube über dem Becken vorgesehen ist, und daß die Haube eine Tropfschutzvorrichtung aufweist. Insbesondere dann, wenn wenigstens zwei Becken zur Behandlung von Substraten nebeneinander angeordnet sind, tritt bei den herkömmlichen Vorrichtungen der Nachteil auf, daß beim Einsetzen oder Ausfahren nasser Substrate und/oder Substratträger Tropfen auf die Hauben benachbarter Behandlungsbecken fallen. Wenn daraufhin die Haube über den Becken verfahren wird, um beispielsweise im Becken abgetrocknete Substrate und/oder Substrathalter aus dem Becken zu entnehmen, ist die Gefahr groß, daß Tropfen seitlich an der Haube ablaufen und auf die jeweils trockenen Substrate fallen. Dieser Nachteil wird durch die erfindungsgemäße Maßnahme, an der Haube eine Tropfschutzvorrichtung vorzusehen, behoben.

Vorzugsweise ist die Tropfschutzhaube eine Abtropfplatte, die entweder auf der Oberseite der Haube angeordnet oder in Form eines Kragens um die Haube herum angebracht bzw. ausgebildet ist. Die Anordnung der Abtropfplatte bzw. des Kragens hängt im wesentlichen von der räumlichen Situation ab und wird entsprechend dem vorhandenen Platz gewählt.

Gemäß einer sehr vorteilhaften Ausführungsform der Erfindung steht die Platte bzw. der Kragen über die Haubenabmessungen hinweg vor, wobei gemäß einer besonders vorteilhaften Ausführungsform der Erfindung die Abtropfplatte und/oder der Kragen zu derjenigen Seite der Haube schräg nach unten weist, in die die Haube bei Öffnen des Beckens verschoben wird. Auf diese Weise ist sichergestellt, daß auf der Seite der Haube, die über das offene Becken hinwegleitet, keine Flüssigkeit ablaufen und ins Becken tropfen kann, weil die Abtropfplatte bzw. der Kragen über die Seitenwandung der Haube hinausragt und von der Seitenwand bzw. von der Haubenoberseite nach oben weist und daher Flüssigkeit nicht abtropfen kann. Die auf die Haube gelangende Flüssigkeit bzw. die an den Seitenflächen bis zum Kragen ablaufenden Tropfen werden über die Abtropfplatte bzw. den Kragen schräg auf die Seite der Haube geführt, die beim Öffnen und Schließen des Beckens nicht über das offene Becken gelangt.

Gemäß einer weiteren Ausführungsform der Erfindung ist über dem Rand des Beckens, über die die Haube nicht verschoben wird, am Becken eine Beckenrand-Abtropfschräge angebracht, die verhindert, daß Flüssigkeit von oben auf den Beckenrand tropfen und diesen verunreinigen bzw. wieder benetzten kann, wenn beispielsweise Substrate und Substrathalter über diesen Bereich transportiert werden.

Die gestellte Aufgabe wird bei den zuvor genannten Vorrichtungen und Anlagen auch dadurch gelöst, daß das Becken eine Reinigungsöffnung aufweist. Bei der Behandlung von Substraten, insbesondere Wafern, im Becken kommt es während der Behandlung oder während der Manipulation der Wafer vor, daß diese brechen oder Teile davon abbrechen, die danach im Becken verbleiben. Diese Rückstände mußten aufwendig von oben entfernt werden. Durch die erfindungsgemäße Maßnahme, das Becken mit einer Reinigungsöffnung zu versehen, ist das Entfernen von Rückständen oder zerbrochenen Wafern wesentlich einfacher. Dazu ist die Reinigungsöffnung vorteilhafterweise mit einem abnehmbaren, vorzugsweise abschraubbaren Flansch abgeschlossen, wobei die Reinigungsöffnung vorteilhafterweise an einer Seite des Beckens am oder nahe dem Beckenboden vorgesehen ist. Dadurch ist ein direkter Zugriff zu den Rückständen und Waferbruchstücke im Tank schnell und unkompliziert möglich.

Die gestellte Aufgabe wird bei den zuvor genannten Anlagen auch dadurch gelöst, daß im Dampfbereich eine Ionisationsvorrichtung zum Verhindern statischer Aufladungen vorgesehen ist. Im Dampfbereich und insbesondere auch durch die Abtropfvorgänge und fließenden Behandlungsfluids, wie destilliertes Wasser usw., entstehen im Behandlungsraum oberhalb der Wasserfläche bzw. in der das Becken nach oben abschließenden Haube Ionen, die zu einer statischen Aufladung führen und Beschädigungen an den Substraten verursachen. Durch die statische Aufladung werden teilweise sehr hohe statische Spannungen aufgebaut, die zu Durchbrüchen führen und auch dadurch die Substrate beschädigen. Durch Erzeugen von Ionen werden die statischen Aufladungen abgebaut und es sind keine Beschädigungen der Wafer mehr durch statische Aufladungen möglich. Im Dampfbereich befindet sich vorzugsweise Stickstoff und/oder Isopropylalkohol.

Gemäß einer vorteilhaften Ausführungsform der Anlage ist eine Ionisationseinrichtung im Dampfbereich vorgesehen, wobei die Ionisationseinrichtung vorzugsweise wenigstens einen Ionisierungsstab an wenigstens einer Innenwand der Haube aufweist. Vorzugsweise umfaßt die Ionisierungseinrichtung wenigstens eine Gegenelektrode, die vorteilhafterweise ebenfalls an einer Innenwand der Haube in einem gewählten Abstand zum Ionisierungstab bzw. zu den Ionisierungstäben angeordnet ist. Die Gegenelektrode liegt vorzugsweise an Masse bzw. am Anschluß einer Hochspannungsquelle, mit derem anderen Anschluß der Ionisierungsstab verbunden ist.

Der Ionisierungsstab ist vorzugsweise mit einer Hochspannung von 5 bis 25 kV beaufschlagt, wobei die Hochspannung gepulst ist. Die Pulse weisen vorzugsweise eine Impulsdauer von 1 bis 100 ms. Vorteilhafterweise ist das Tastverhältnis der Impulse im Bereich von 1:8 bis 1:12.

Eine Verbesserung der Fertigungsqualität wird bei den zuvor genannten Anlagen auch dadurch erreicht, daß wenigstens eine Meßsonde zur Überwachung der Gaskonzentration, der Gasgemisch-Anteile und/oder des Gas- bzw. Gasgemischgehalts im Dampfbereich vorgesehen ist. Vorzugsweise werden die von der Meßsonde ermittelten Meßwerte zur Steuerung bzw. Regelung der Gaskonzentration, der Gasgemisch-Anteile und/oder des Gas- bzw. Gasgemischgehalts im Dampfraum herangezogen. Auf diese Weise ist es möglich, L über den gesamten Fertigungs- und Behandlungsablauf optimale Verhältnisse im Dampfbereich aufrecht zu erhalten, so daß eine hohe Fertigungsqualität und geringer Ausschuß gewährleistet ist.

Die Fertigungsqualität wird gemäß einer weiteren erfindungsgemäßen Ausführungsform der zuvor genannten Vorrichtungen auch dadurch erreicht, daß in einer Leitung, über die das Behandlungsfluid abfließt, ein Flowmeter zur Ermittlung der Durchflußmenge des Behandlungsfuids angeordnet ist. Dadurch ist es möglich, abweichende Durchflußmengen schnell festzustellen und/oder die vom Flowmeter ermittelten Meßwerte zur Steuerung bzw. Regelung der ein- und/oder ausströmenden Fluidmenge heranzuziehen. In der Zu- und/oder Abflußleitung ist dazu vorzugsweise ein Ventil, insbesondere ein von einem Motor gesteuertes Ventil vorgesehen, wobei der Motor bzw. das Ventil in Abhängigkeit von den Meßwerten des Flowmeters gesteuert bzw. geregelt wird.

Bei den zuvor beschriebenen Anlagen werden die Fertigungskosten erfindungsgemäß dadurch klein gehalten, daß das aus dem Becken ausströmende Behandlungsfluid in einer Wiederaufbereitungsanlage wiederaufbereitet wird. Dies verringert nicht nur die Herstellungskosten sondern dient auch der Umweltverträglichkeit des Verfahrens. Das wiederaufbereitete Fluid wird vorzugsweise im Fluidbecken wieder verwendet. Das gesamte wiederaufbereitete Fluid oder ein Teil hiervon kann nach der Wiederaufbereitung auch in die Brauchwasserableitung abgelassen werden. Dies ist insbesondere dann von Vorteil, wenn das Fluid etwa bei einem Trocknungsverfahren von Substraten destilliertes Wasser ist, das nach der Aufbereitung problemlos in das kommunale Abwassersystem eingeleitet werden kann.

Bevorzugterweise wird die erfindungsgemäße Aushubvorrichtung bei einem Trocknungsverfahren eingesetzt. Dabei werden die Substrate aus einem Spülfluid ausgehoben und der Substrathalter im Becken belassen. Anschließend wird der Fluidspiegel unter den Substrathalter abgesenkt, was beispielsweise durch Öffnen eines Abflusses bewirkt wird. Anschließend werden die getrockneten Substrate zurück in den ebenfalls trockenen Substrathalter abgesenkt. Die Trocknung der Substrate geschieht also während des Ausbringens der Substrate aus einem Becken, während der Substratträger durch das Absenken des Flüssigkeitsspiegels des Spülfluids getrocknet wird.

Die Erfindung sowie weitere Einzelheiten und Vorteile derselben wird bzw. werden nachfolgend anhand von Ausführungsbeispielen unter Bezugnahme auf die Zeichnungen erläutert. Es zeigen:
- Fig. 1: eine Ansicht der Rückseite einer Ausführungsform einer Aushubvorrichtung für eine erfindungsgemäße Trockungsanlage;
- Fig. 2: eine Seitenansicht der Aushubvorrichtung gemäß der Fig. 1;
- Fig. 3: eine Querschnittsansicht der Trocknungsanlage zur chemischen Naßbehandlung und gleichzeitig einen ersten Schritt eines erfindungsgemäßen Trocknungsvorgangs;
- Fig. 4: einen zweiten Schritt eines erfindungsgemäßen Trocknungsvorgangs;
- Fig. 5: einen dritten Schritt eines erfindungsgemäßen Trocknungsvorgangs;
- Fig. 6: einen vierten Schritt eines erfindungsgemäßen Trocknungsvorgangs;
- Fig. 7: einen fünften Schritt eines erfindungsgemäßen Trocknungsvorgangs;
- Fig. 8: einen sechsten Schritt eines erfindungsgemäßen Trocknungsvorgangs;
- Fig. 9: einen siebten Schritt eines erfindungsgemäßen Trocknungsvorgangs;
- Fig. 10: einen achten Schritt eines erfindungsgemäßen Trocknungsvorgangs
- Fig. 11: eine Ausführungsform der erfindungsgemäßen Vorrichtung in schematischer Darstellung mit einer Abtropfplatte über der Haube
- Fig. 12: eine weitere Ausführungsform der erfindungsgemäßen Vorrichtungmit einer Tropfschutzvorrichtung in Form eines um eine Haube herum angeordneten Kragens;
- Fig. 13: die Ausführungsform gemäß Fig. 12 in Aufsicht;
- Fig. 14: eine Seitenansicht einer Ausführungsform der erfindungsgemäßen Vorrichtung mit einer Reinigungsöffnung im Becken;
- Fig. 15: einen schematischen Querschnitt entlang der in Fig. 14 eingezeichneten Schnittlinie I-I und
- Fig. 16: eine Ausführungsform der Haube mit einer Ionisationseinrichtung in schematischer Darstellung.

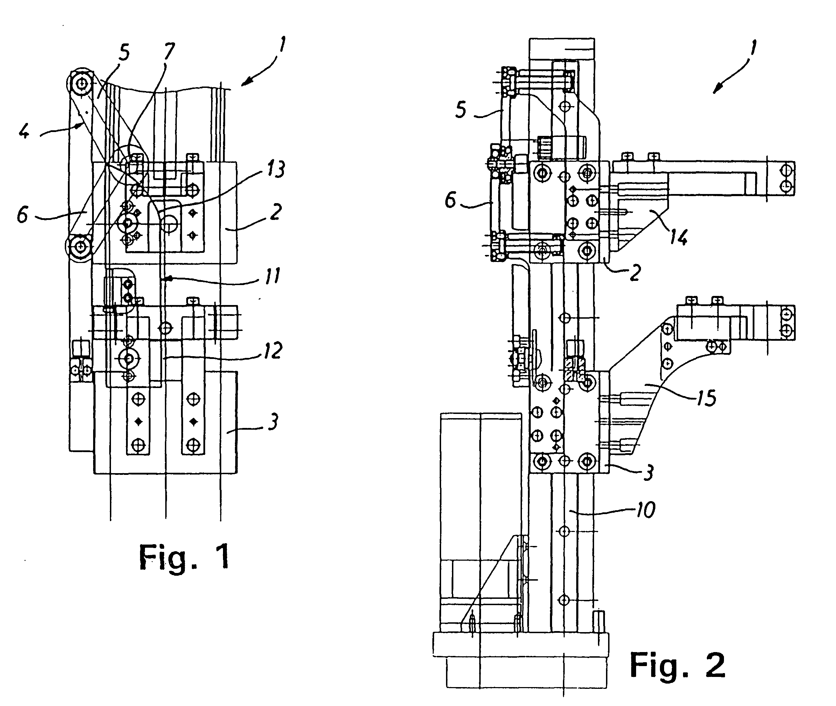

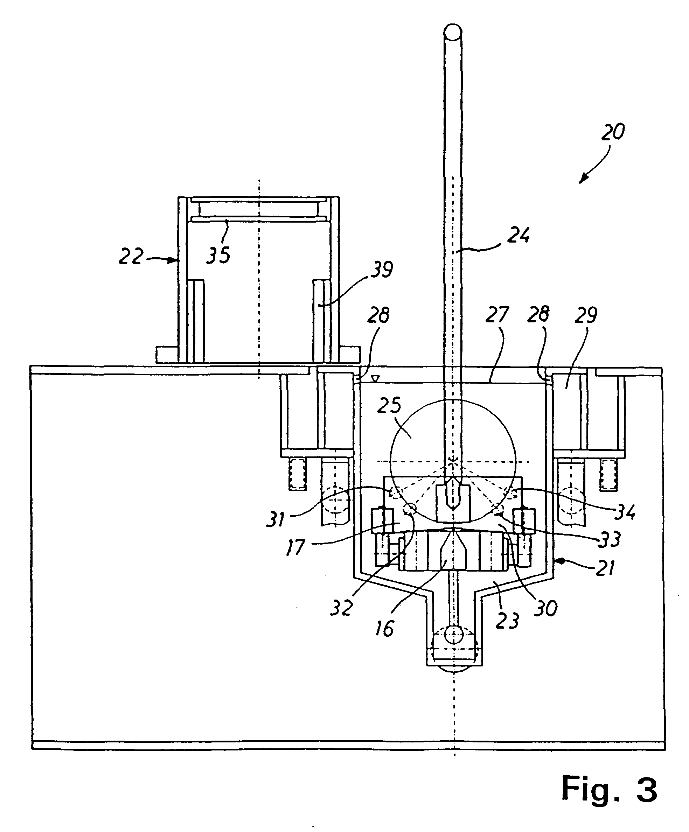

In den Fig. 1 und 2 ist eine Aushubvorrichtung 1 einer erfindungsgemäßen Anlage 20 zur Trockung von Wafern 25 entsprechend Fig. 3 dargestellt. Die Aushubvorrichtung 1 weist einen ersten Transportschlitten 2 mit einem Trägerarm 14 für eine messerartige Anhebevorrichtung 16 und einen zweiten Transportschlitten 3 mit einem Trägerarm 15 für den Subtratträger 17 auf, die durch eine Gelenkverbindung 4 miteinander verbunden sind. Die Gelenkverbindung 4 umfaßt einen ersten Schenkel 5 und einen zweiten Schenkel 6, der mit dem ersten Transportschlitten 2 bzw. mit dem zweiten Transportschitten 3 gelenkig verbunden ist. Die beiden Schenkel 5, 6 stehen über einen Stift 7 miteinander in Verbindung. Der erste Transportschlitten 2 wird von einem (nicht gezeigten) Motor angetrieben und zieht beim Aushub über die Gelenkverbindung 4 den zweiten Transportschlitten 3 auf einer Führungsschiene 10 mit nach oben. Dabei läuft der Stift 7 eine Steuerkurve 11 ab, die aus einem geraden Abschnitt 12 und einem krummen Kurvenabschnitt 13 besteht.

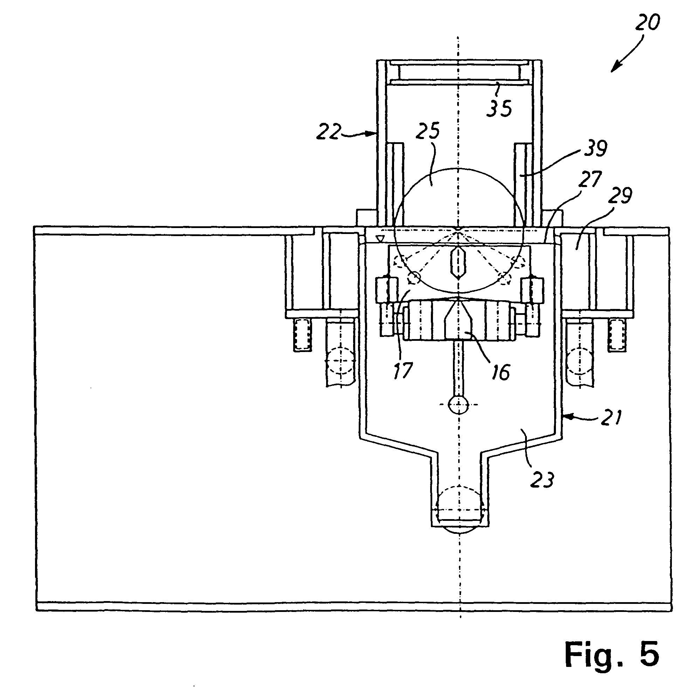

Bewegt sich der Stift 7 auf dem geraden Abschnitt 12, so bildet die Gelenkverbindung 4 im wesentlichen eine starre Verbindung zwischen dem ersten und zweiten Transportschlitten 2, 3. In diesem Zustand wird der Substratträger 17 mit den darin befindlichen Wafern 25 angehoben, während die messerartige Anhebevorrichtung 16 noch nicht an den Wafern 25 anliegt. Ab Beginn des Kurvenabschnitts 13 der Steuerkurve 11 wird der zweite Transportschlitten 3 allmählich langsamer als der erste Transportschlitten 2. Dadurch kommt die messerartige Anhebevorrichtung 16 in Berührung mit den Wafern 25 und hebt diese an und aus den Halterungen des Substratträgers 17 heraus. Zu diesem Zeitpunkt werden die Wafer 25 jedoch bereits in Führungen 39 einer Haube 22 gehalten, wie dies aus der nachfolgenden noch zu beschreibenden Figur 5 ersichtlich ist. Der Transportschlitten 3 kommt dabei jedoch nicht vollständig zum Stillstand, sondern läuft entsprechend der Kurvenform des Kurvenabschnitts 13 der Bewegung des ersten Transportschlittens 2 nach, da die Schenkel 5, 6 die Möglichkeit haben, sich um den Stift zu drehen und dadurch ihren Winkel zueinander kontinuierlich zu vergrößern. Der Zeitpunkt des Stillstands des zweiten Transportschlittens 3 ist dann erreicht, wenn der Stift 7 an einer Stelle des Kurvenabschnitts 13 gelangt ist, an der er in einen Kreisbogen übergeht, dessen Radius dem Abstand zwischen Stiftachse und der Drehächse des Verbindungspunktes zwischen dem zweiten Schenkel 6 und dem zweiten Transportschlitten 3 entspricht. Das Eigengewicht des Transportschlitten 3 bewirkt dabei den Stillstand.

Der Radius des Bereichs des Kurvenabschnitts 13, der sich zwischen dem geraden Abschnitt 12 und dem Stillstandspunkt des Kurvenabschnitts 13 befindet, ist dabei größer als der Radius des Bereichs des Kurvenabschnitts 13 nach dem Stillstandspunkt.

In den Fig. 3 bis 10 ist der Ablauf eines Trocknungsverfahrens unter Verwendung der dort nicht dargestellten Aushubvorrichtung 1 wiedergegeben. In den Fig. 3 bis 10 bezeichnen gleiche Bezugszeichen gleiche Elemente.

Gemäß Fig. 3 weist die erfindungsgemäße Anlage 20 ein Becken oder einen Behälter 21 auf, über den seitlich eine Haube 22 geschoben wird. Innerhalb des Beckens 21 ist die von dem Substratarm 14 getragene messerartige Anhebevorrichtung 16 sichtbar.

Ein Substratträger 17 mit darin angeordneten Wafern 25 wird von einem Anlagenhändler 24 auf die in ihrer unteren Endstellung befindliche Aushubvorrichtung 1 aufgesetzt. Ein Spülfluid 23 strömt von unten in das Becken 21 und strömt über eine Überlaufkante 28 in ein äußeres Überlaufbecken 29. Da sich die Aushubvorrichtung 1 in ihrer unteren Endstellung befindet, sind die Wafer 25 vollständig in das Spülfluid 23 eingetaucht.

Der Substratträger 17 besitzt zwei parallel angeordnete Seitenplatten, von denen in der Ansicht der Figur 3 nur eine Seitenplatte 30 erkennbar ist. Zwischen den Seitenplatten sind vier Stäbe 31, 32, 33, 34 mit Querschlitzen für die Aufnahme der Wafer 25 angebracht.

Ein Gas wird von oben in die Haube 22 geleitet und tritt über die Überlauföffnungen des Beckens aus dem Trocknungsraum aus.

Die Einleitung des für die Trocknung verwendeten Gases erfolgt über ein Längsrohr innerhalb des oberen Deckelbereichs der Haube 22. Die zwischen dem Längsrohr und dem Deckelinnenvolumen angeordnete Diffusorplatte besitzt ein definiertes Lochbild, das eine gleichmäßige Gasverteilung über die Breite und Länge des Deckes bewirkt. Wenn gleichzeitig mehrere Substratträger 17 in einer Trocknungsanlage 20 pozessiert werden, befinden sich vorzugsweise im Deckel an den Frontseiten der Waferpakete jeweils Trennwände, die dafür sorgen, daß in der Haube 22 für die einzelnen Waferpakete eine gleichmäßige Verteilung des Gases, vorzugsweise eines IPA/N₂-Gemisches für den gesamten Raum garantiert wird. Andernfalls könnten sich unterschiedliche Strömungs-Verhältnisse ergeben, so daß einzelne Wafer 25 der Pakete unterschiedliche Trocknungsergebnisse aufweisen. Zur Führung der Wafer 25 sind an gegenüberliegenden Innenseitenflächen Führungsschlitze 39 ausgebildet. Die Führungsschlitze 39 in der Haube 22 sind um etwa 5 Grad geneigt. Entsprechend werden die Substratträger 17 mit dem gleichen Neigungswinkel in das Becken 21 abgesenkt. Dadurch ist die Lage der Wafer 25 während des gesamten Trocknungsprozesses definiert und die Trocknung des Substratträgers wird ebenfalls verbessert.

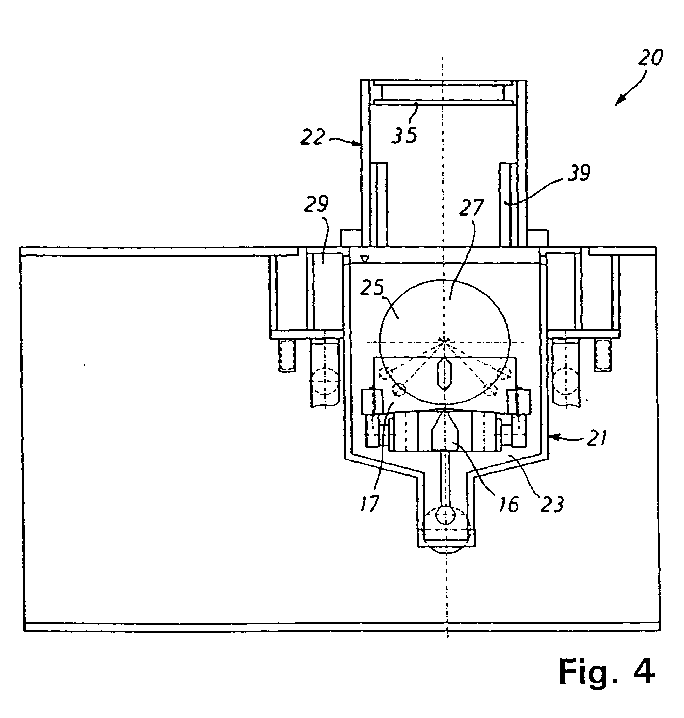

Die Darstellung der erfindungsgemäßen Anlage gemäß Fig. 4 unterscheidet sich von der in Fig. 3 lediglich dadurch, daß die Haube 22 über das Becken 21 gefahren ist. Danach wird der Substratträger 17 mit dem Wafer 25 angehoben.

Dabei läuft der Stift 7 durch den Antrieb des ersten Transportschlittens 2 auf dem geraden Abschnitt 12 der Steuerkurve 11 ab.

In Fig. 5 ist der Punkt der Bewegung erreicht, an dem der Stift 7 den geraden Abschnitt 12 der Steuerkurve 11 verläßt und den Kurvenabschnitt 13 der Steuerkurve 11 abzulaufen beginnt. Die Form und Größe der Steuerkurve 11 ist derart ausgebildet, daß dieser Punkt dann erreicht wird, wenn die Wafer 25 mit den seitlichen Führungen 39 in der Haube 22 in Eingriff kommen, so daß der Substratträger 17 nicht mehr zur Führung der Wafer 25 benötigt wird. Die Wafer 25 werden danach durch die messerartige Aushebevorrichtung 16 angehoben.

Nach dem Ausfahren der Wafer 25 aus dem Spülfluid 23 werden die Wafer 25 getrocknet. Der Trocknungsvorgang wird durch die IPA/N₂-Atmosphäre oberhalb des Behälters 21 unterstützt, da sich das Gas mit dem Spülfluid 23 auf den Substraten 25 mischt und durch den Gradienten in den Oberflächenspannungskräften verhindert wird, daß ein Flüssigkeitsfilm auf dem Substrat 25 verbleibt.

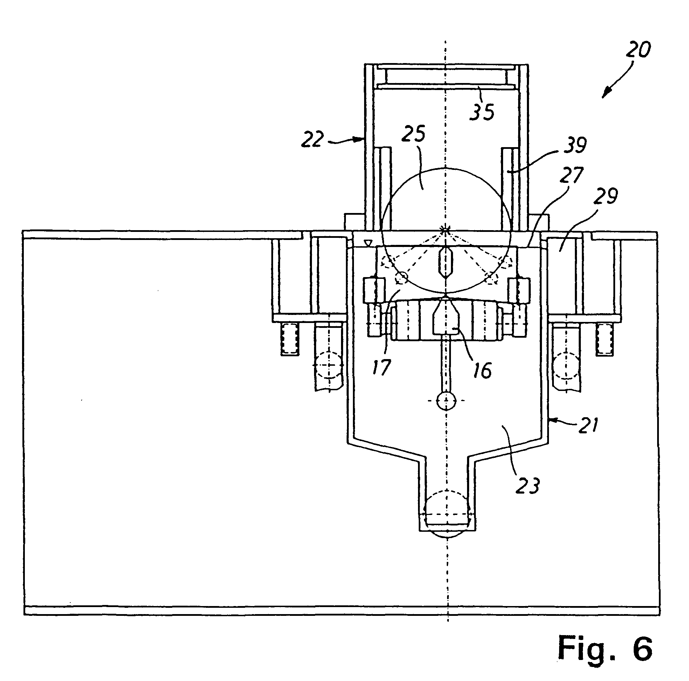

Gemäß Fig. 6 bleibt der Substratträger 17 langsam gegenüber der messerartigen Aushebevorrichtung 16 zurück. Dadurch übernimmt die messerartige Aushebevorrichtung 16 das weitere Ausheben der Wafer 25 aus dem Behälter 21.

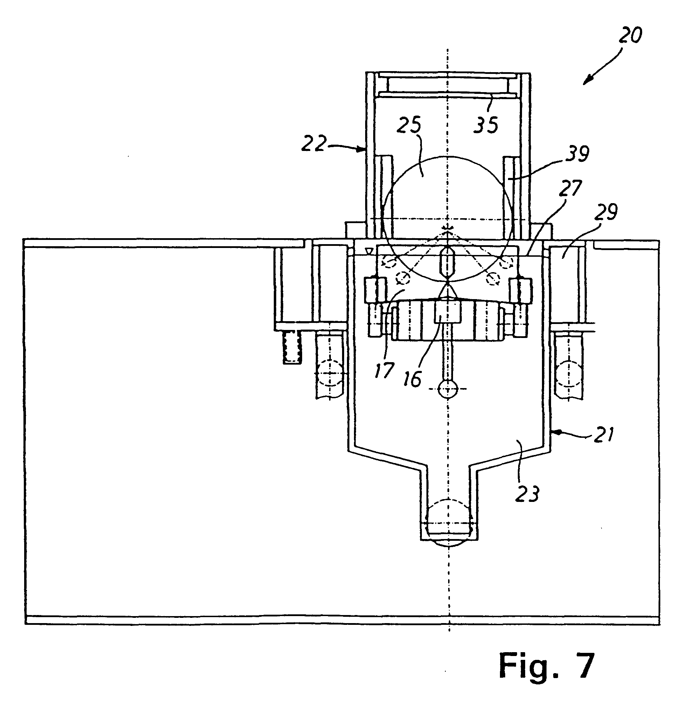

In Fig. 7 ist die Stellung des Substratträgers 17 gezeigt, in der dieser vollständig stehen bleibt und sich nur noch die messerartige Aushebevorrichtung 16 nach oben bewegt. Dadurch wird der Substratträger 17 nicht an die Führungen 39 der Haube 22 gedrückt, was andernfalls zu einer Beschädigung der Führungen und einer Zerstörung des Substratträgers 17 führen würde.

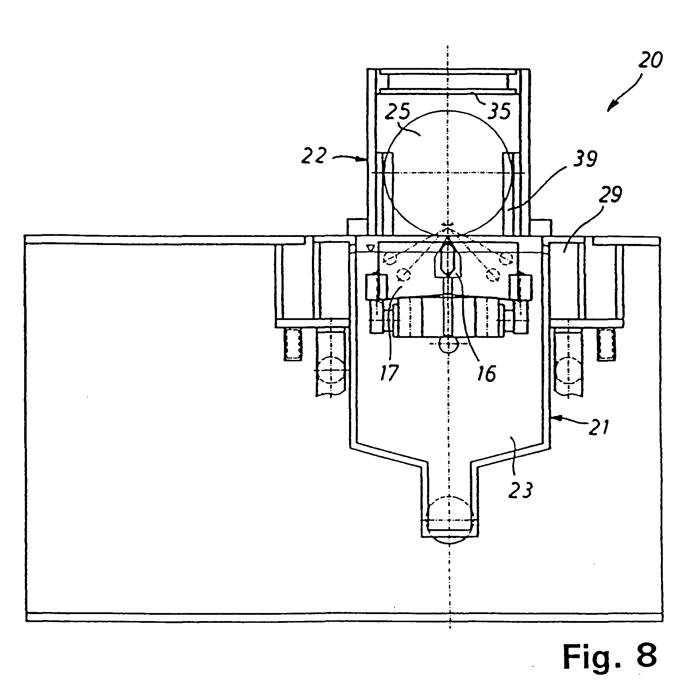

Fig. 8 zeigt das Ende des Trocknungsvorgangs der Substrate 25. Die Wafer 25 haben den höchsten Punkt ihrer Bewegung erreicht und sind vollständig über den Flüssigkeitsspiegel 27 herausgehoben. Um die Substratträger 17 zu trocknen, wird der Flüssigkeitsspiegel durch Öffnen eines Ablaufes gesenkt. Die Wafer 25 und die Substratträger 17 befinden sich dann in der IPA/N₂-Atmosphäre befinden.

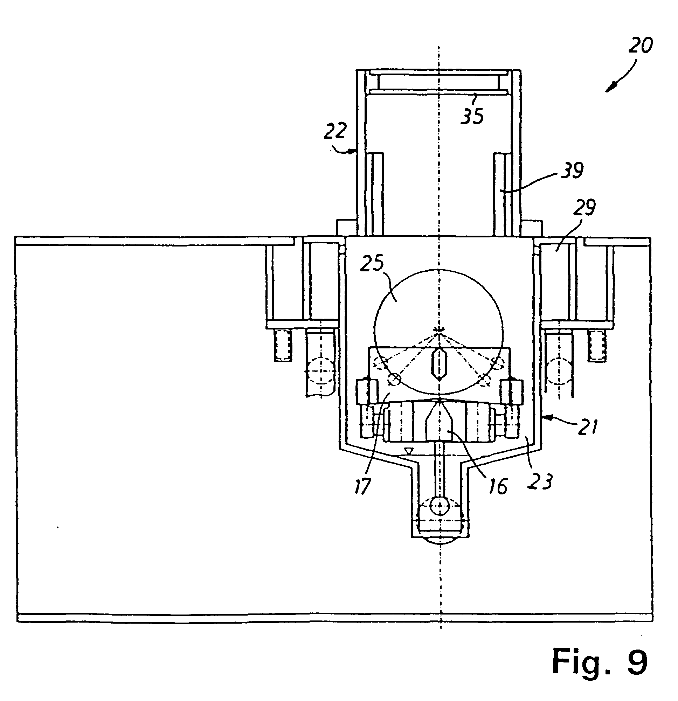

In Fig. 9 ist der Flüssigkeitsspiegel 27 des Spülfluids 23 unter den Substratträger 17 abgesunken. Inzwischen wurde der anhand der Figuren 4 bis 7 beschriebene Bewegsvorgang in umgekehrter Reihenfolge durchgeführt, so daß sich der Substratarm 14 und der Substratträgerarm 15 wieder in ihren unteren Endstellungen befinden. Die Wafer 25 und der Substratträger 17 sind dann getrocknet.

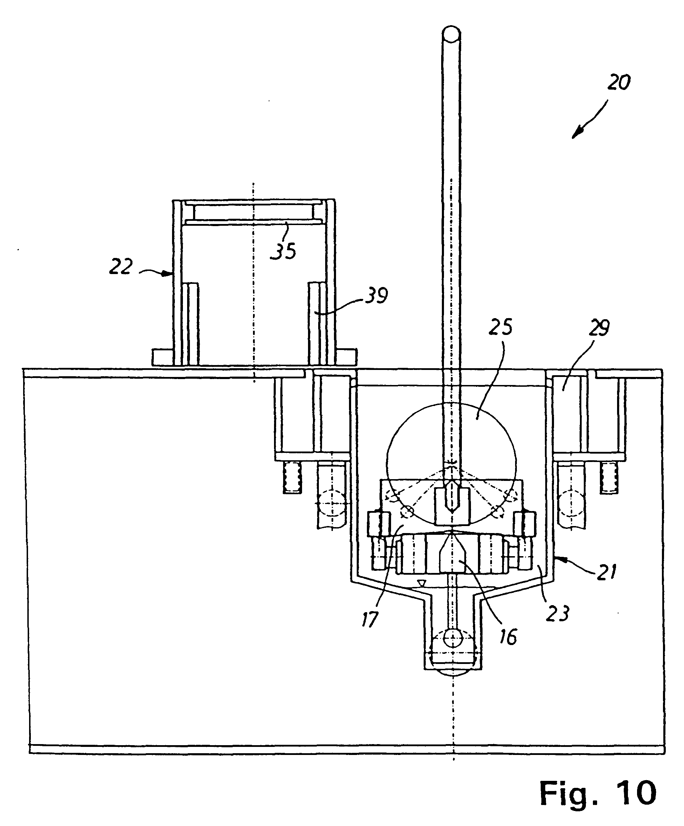

Gemäß Fig. 10 wird die Haube 22 seitlich verschoben, so daß der Substratträger 17 mit den Wafern 25 durch den Anlagenhandler 24 aus dem Behälter 21 entfernbar ist.

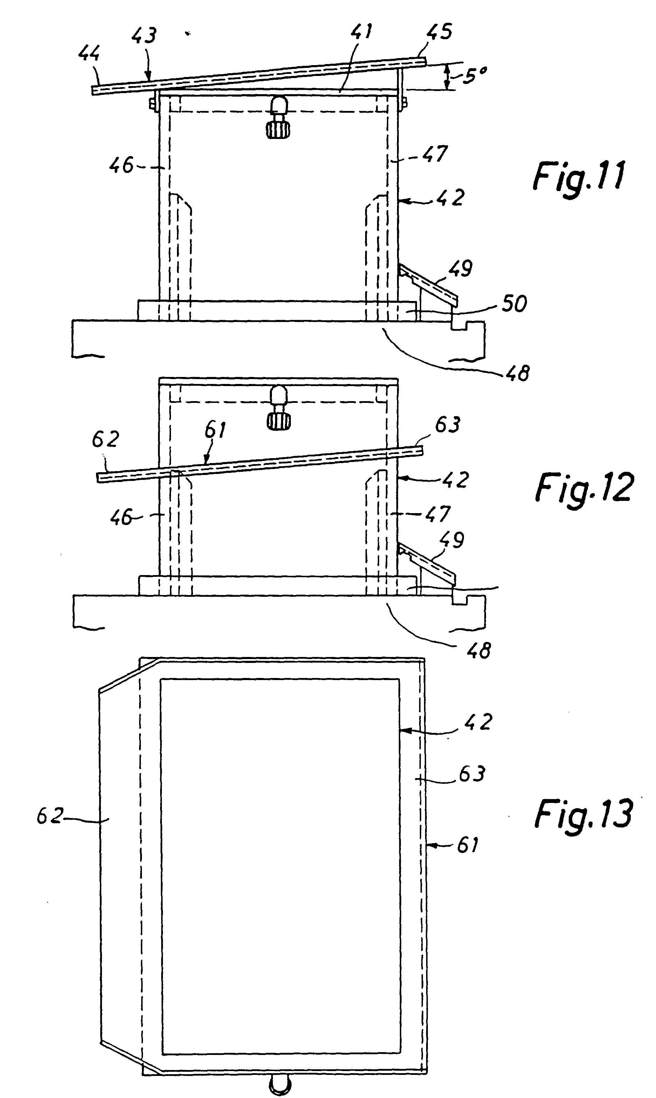

Bei der in Fig. 11 dargestellten Ausführungsform einer Vorrichtung zum chemischen Behandeln von Substraten ist über einer oberen Wandung 41 einer Haube 42 eine Tropfschutzeinrichtung in Form einer Abtropfplatte 43 vorgesehen, die in einem Winkel von beispielsweise 5° zur oberen Wand 41 der Haube 42 angebracht ist. Die Abdeckplatte 43 ragt mit ihren seitlichen Enden 44, 45 über die Seitenwände 46, 47 der Haube 42 hinaus. Insbesondere dann, wenn mindestens zwei Behandlungsbecken nebeneinander angeordnet sind, werden behandelte, mit Flüssigkeit benetzte Substrate bzw. Substratträger über die Haube 42 transportiert, so daß nicht vermieden werden kann, daß Flüssigkeit auf die Haube 42 bzw. gemäß der vorliegenden Erfindung auf die Abtropfplatte 43 tropft. Ohne Vorhandensein der Abtropfplatte 43 würde diese Flüssigkeit an den Seiten 46, 47 der Haube 42 als Tropfen abfließen und bei Öffnen der Haube 42 beispielsweise durch Verschieben nach links insbesondere von der Seitenwand 47 in ein lediglich schematisch dargestelltes Becken 48 tropfen, in dem sich ein anderes Behandlungsfluid oder bereits getrocknete Substrate und/oder Substratträger befindet bzw. befinden, so daß das Behandlungsfluid verunreinigt wird bzw. die bereits trockenen Substrate oder Substrat-träger wieder naß werden. Die dadurch entstehenden Nachteile, wie beispielsweise häufigeres Auswechseln des Behandlungsfluids oder Ausschuß durch wieder mit Flüssigkeit benetzte Wafer werden erfindungsgemäß mit der vorgesehenen Abtropfplatte 43 vermieden. Die Abtropfplatte 43 verhindert ein Herunterlaufen von Tropfen an den Seitenflächen 46, 47 der Haube 42 und insbesondere auch an der Seitenfläche 47, die etwa beim Verfahren der Haube 42 nach links zur Öffnung des Beckens 48 über das offene Becken 48 gelangt. Durch die schräge Anordnung der Abtropfplatte 43 in Richtung derjenigen Seite nach unten, in die die Haube 42 verfahren wird, läuft bzw. tropft die Flüssigkeit von der Abtropfplatte 43 außerhalb des Beckenbereichs ab und gelangt daher nicht in das Becken 48.

Bei der dargestellten Ausführungsform ist auf der Seite des Beckens 48, über die die Haube 42 beim Öffnen des Beckens nicht bewegt wird, eine zusätzliche Beckenwand-Abtropfschräge 49 über diesem Beckenrand 50 am Becken befestigt, über die die von oben auf die Abtropfschräge 49 tropfende Flüssigkeit abgeleitet wird und den Beckenrand 50 nicht erreicht.

Die in den Fig. 12 und 13 dargestellte Ausführungsform unterscheidet sich von der in Fig. 11 dargestellten Ausbildung im wesentlichen lediglich dadurch, daß die Abtropfschutzvorrichtung in diesem Falle in Form eines Kragens 61 ausgebildet ist, der im Bereich zumindest der Seitenwände 46 und 47 der Haube 42 um die Haube 42 herum oder zumindest im Bereich der Seitenwände 46, 47 angeordnet ist. Durch die überstehenden Bereiche 62, 63 des Kragens 61 ist wiederum in entsprechender Weise, wie dies anhand von Fig. 11 im einzelnen ausgeführt wurde, gewährleistet, daß beim Öffnen des Beckens 48 durch Verschieben der Haube 42 in der Zeichenebene nach links Flüssigkeit, die von oben auf die Haube 2 gelangt, nicht an den Seitenwänden 46, 47 entlang nach unten in das offene Becken 48 abtropfen kann. Die in Fig. 12 dargestellte Beckenrandschräge 49 entspricht derjenigen von Fig. 1 und hat auch diesselbe Funktion.

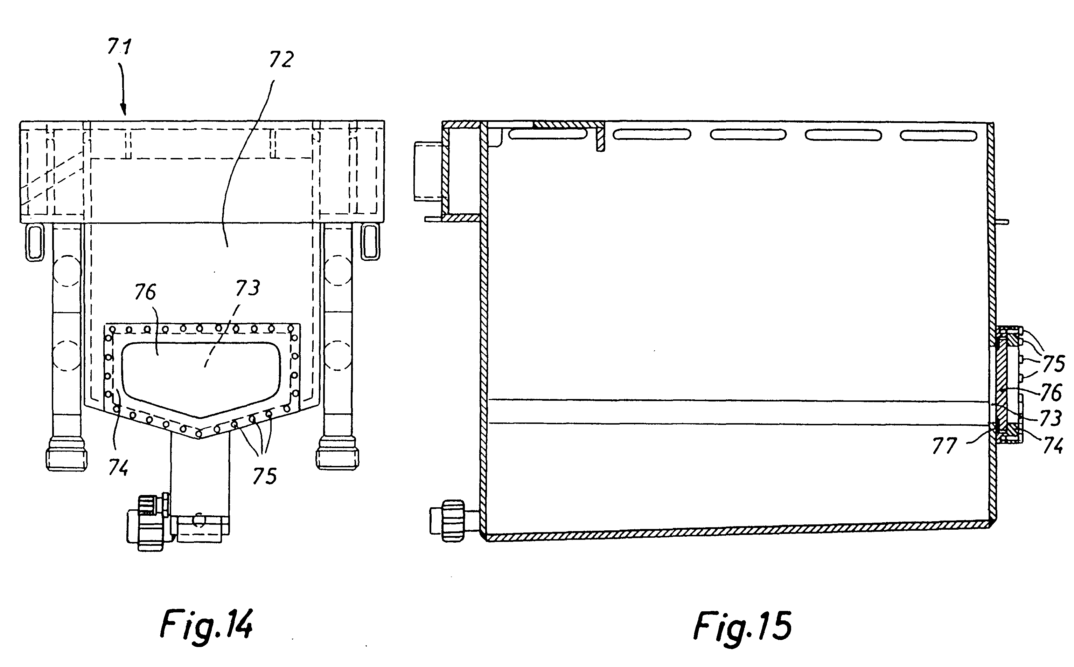

Bei der in den Fig. 14 und 15 dargestellten Ausführungsform des Beckens 71 ist an seiner schmalen Seite 72 ein Reinigungsloch 73 vorgesehen, das am unteren Ende in der Nähe des Beckenbodens ausgeschnitten ist.

Wie insbesondere anhand von Fig. 15 ersichtlich ist, ist das Reinigungsloch 73 mit einem abnehmbaren Flansch 74 verschlossen und über Schrauben 75 am Becken 71 befestigt. Zwischen dem Flansch 74 und dem Becken 71 ist bei der dargestellten Ausführungsform weiterhin ein Zwischenflansch 76 vorgesehen. Zur Abdichtung ist an den Rändern des Flansches 74 und/oder des Zwischenflansches 76 eine umlaufende Dichtung 77 angeordnet.

Die Reinigungsöffnung 73 im Becken 71 erlaubt ein einfaches Reinigen des Tankbodens und das problemlose Entfernen von Rückständen oder zerbrochenen Substraten.

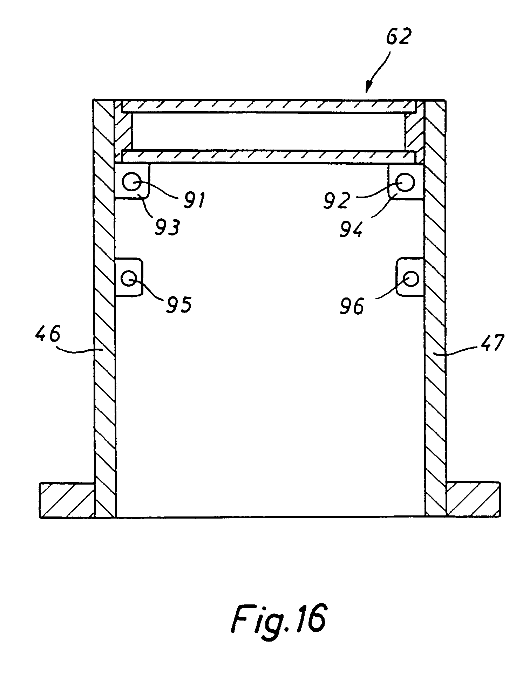

Bei der in Fig. 16 dargestellten Ausführungsform ist eine Ionisierungsvorrichtung mit Ionisierungsstäben 91, 92 an beiden Seiten 46, 47 der Haube 42 vorgesehen, die in diesem Ausführungsbeispiel jeweils mit Befestigungseinrichtungen 93, 94 im oberen Randbereich der Haube 42 fixiert sind.

In einem gewählten Abstand unterhalb der Ionisierungsstäbe 91, 92 befindet sich jeweils eine Gegenelektrode 95, 96, die beispielsweise geerdet sind oder an Masse liegen.

Durch Anlegen einer Hochspannung zwischen dem jeweiligen Ionisierungsstab 91, 92 und der zugeordneten Gegenelektrode 95 bzw. 96 werden Ionen erzeugt, die eine statische Aufladung der Substrate, der Substratträger und/oder von Bauteilen der Behandlungsvorrichtung vermeiden. Auf diese Weise wird sichergestellt, daß die mit statischen Aufladungen verbundenen Nachteile, wie Durchschläge oder Überschläge nicht auftreten und Beschädigungen der Substrate nicht möglich sind.

Die Erfindung wurde anhand bevorzugter Ausführungsbeispiele erläutert. Dem Fachmann sind jedoch zahlreiche Abwandlungen und Ausgestaltungen möglich. Beispielsweise ist es möglich, die Tropfschutzvorrichtung in Form einer Abtropfplatte 43 oder eines Kragens 61 an der Haube 42 je nach den vorhandenen Raumverhältnissen weiter oben oder weiter unten anzuordnen, oder das Maß der Schräge nach den jeweiligen Erfordernissen zu wählen. Weiterhin ist es beispielsweise möglich, mehrere Ionisierungsstäbe 91, 92 und mehrere Gegenelektroden 95, 96 vorzusehen und verteilt über den Behandlungsraum anzuordnen, um eine optimale, gleichmäßige Ionisation innerhalb der Haube 42 zu erreichen.

## Patentansprüche

1. Anlage (20) zur chemischen Naßbehandlung von Substraten (25) in einem ein Behandlungsfluid (23) enthaltenden Behälter (21), mit einer Aushubvorrichtung (1) zum Ein- und Ausbringen wenigstens eines Substratträgers (17) und der Substrate (25), wobei die Aushubvorrichtung (1) einen ersten Transportschlitten (2) für eine Substrat-Anhebevorrichtung (16) und einen zweiten Transportschlitten (3) für einen Substratträger-Halter aufweist, **dadurch gekennzeichnet**, daß die beiden Transportschlitten (2, 3) über eine Gelenkverbindung (4) miteinander verbunden sind.

2. Anlage (20) nach Anspruch 1, **dadurch gekennzeichnet**, daß der erste und der zweite Transportschlitten (2, 3) auf einer vertikalen Führungsschiene (10) bewegbar ist, und daß der erste Transportschlitten (2) vorzugsweise mit einer Antriebsvorrichtung verbunden ist.

3. Anlage (20) nach einem der vorhergehenden Ansprüche, **dadurch gekennzeichnet**, daß die Gelenkverbindung (4) zwei Schenkel (5, 6) aufweist, wobei ein erster Schenkel (5) mit dem ersten Transportschlitten (2) und ein zweiter Schenkel (6) mit dem zweiten Transportschlitten (3) gelenkig, und die den Transportschlitten (2, 3) abgewandten Enden der ersten und zweiten Schenkel (5, 6) miteinander über einen Stift (7) drehbar verbunden sind.

4. Anlage (20) nach Anspruch 3, **dadurch gekennzeichnet**, daß ein vorstehender Bereich des die beiden Schenkel (5, 6) verbindenden Stiftes an einer Steuerkurve (11) abläuft.

5. Anlage (20) nach Anspruch 4, **dadurch gekennzeichnet**, daß die Steuerkurve (11) einen geraden, parallel zur Bewegungsrichtung der Transportschlitten (2, 3) verlaufenden Abschnitt (12) und einen sich an den geraden Abschnitt anschließenden Kurvenabschnitt (13) aufweist, daß der Abstand zwischen dem ersten und zweiten Transportschlitten (2, 3) konstant ist, wenn der Stift (7) auf dem geraden Abschnitt (12) abläuft, daß sich der Abstand zwischen dem ersten und zweiten Transportschlitten (2, 3) vergrößert, wenn der Stift (7) auf dem Kurvenabschnitt (13) abläuft, daß die Form des Kurvenabschnitts (13) vorzugsweise so gewählt ist, daß sich der Abstand zwischen dem ersten und zweiten Transportschlitten (2, 3) stetig vergrößert, und daß die Form des Kurvenabschnitts (13) in seinem Endbereich vorzugsweise so gewählt ist, daß der zweite Transportschlitten (3) allmählich zum Stillstand kommt.

6. Anlage (20) nach einem der Ansprüche 4 oder 5, **dadurch gekennzeichnet**, daß der erste Transportschlitten (2) mit einer messerartigen Anhebevorrichtung (16) verbunden ist, daß die messerartige Anhebevorrichtung (16) und der Substratträger (17) mit gleicher Geschwindigkeit angehoben werden, wenn der Stift (7) auf dem geraden Abschnitt (12) der Steuerkurve (11) abläuft, daß der zweite Transportschlitten (3) zum Stillstand kommt, wenn die Substrate (25) in Führungen (39) außerhalb des Substratträgers (17) in Eingriff kommen, und daß die Führungen vorzugsweise in einer Haube (22) oberhalb des Behälters (21) ausgebildet sind.

7. Anlage (20) nach Anspruch 6, **dadurch gekennzeichnet**, daß der Aushub der Substrate (25) nach dem Stillstand des zweiten Transportschlittens (3) durch die messerartige Anhebevorrichtung (16) erfolgt.

8. Anlage (20) nach einem der vorhergehenden Ansprüche, **dadurch gekennzeichnet**, daß die Anlage (20) zum Spülen und/oder Trocknen von Substraten (25) vorgesehen ist.

9. Anlage (20) nach einem der vorhergehenden Ansprüche, gekennzeichnet durch eine Gaseinlaßvorrichtung zum Beaufschlagen der Substrate und/oder des Substratträgers während des Trocknungsvorgangs mit einem Gas, insbesondere einem Gasgemisch aus Isopropylalkohol und Stickstoff.

10. Anlage (20) nach einem der vorhergehenden Ansprüche, **dadurch gekennzeichnet**, daß zusätzlich ein lös- und arretierbarer Klinkmechanismus vorgesehen ist, der den ersten und zweiten Transportschlitten (2, 3) starr miteinander verbindet, und daß vorzugsweise ein Zylinder vorgesehen ist, der den Klinkmechanismus ent- und/oder verriegelt.

11. Anlage nach einem der vorhergehenden Ansprüche, **dadurch gekennzeichnet**, daß eine verschiebbare Haube (42) über dem Behälter (48) vorgesehen ist, und daß die Haube (42) eine Tropfschutzvorrichtung (43, 61) aufweist, daß die Tropfschutzvorrichtung eine Abtropfplatte (43) und vorzugsweise auf der Oberseite der Haube (42) angeordnet ist.

12. Anlage nach einem der vorhergehenden Ansprüche, **dadurch gekennzeichnet**, daß eine verschiebbare Haube (42) über dem Behälter (48) vorgesehen ist, die eine Tropfschutzvorrinchtung (43, 61) aufweist, welche als Kragen (61) um die Haube (42) herum angeordnet ist.

13. Anlage nach Anspruch 11 bis 12, **dadurch gekennzeichnet**, daß die Abtropfplatte (43) bzw. der Kragen (61) über die Haube (42) hinweg vorsteht, daß die Abtropfplatte (43) bzw. der Kragen (61) vorzugsweise zu derjenigen Seite (45) der Haube (42) schräg nach unten weist, in die die Haube (42) bei Öffnen des Behälters (48) verschoben wird, und daß über dem Rand (50) des Behälters (58), über die die Haube (42) nicht verschoben wird, vorzugsweise eine Beckenrand-Abtropfschräge (49) vorgesehen ist.

14. Anlage nach einem der vorhergehenden Ansprüche, **dadurch gekennzeichnet**, daß der Behälter (71) eine Reinigungsöffnung (73) aufweist, daß die Reinigungsöffnung (73) mit wenigstens einem Flansch (74, 76) abgeschlossen ist, und daß die Reinigungsöffnung (73) an einer Seite (72) des Behälters (71) vorzugsweise am oder nahe dem Beckenboden vorgesehen ist.

15. Anlage nach einem der vorhergehenden Ansprüche, **dadurch gekennzeichnet**, daß eine Ionisationsvorrichtung in einer bzw. der in Ansprüchen 11-13 erwähnten Haube (42) über dem Behälter (48) vorgesehen ist.

16. Anlage nach Anspruch 15, **dadurch gekennzeichnet**, daß die Ionisationsvorrichtung in einem Dampfbereich vorgesehen ist, in dem das aus dem Behälter herausgefahrene Substrat einem bzw. dem in Anspruch 9 erwähnten Gas, vorzugsweise Stickstoff und/oder Isopropylalkohol, ausgesetzt ist, daß die Ionisierungsvorrichtung wenigstens einen Ionisierungsstab (91, 92) an wenigstens einer Innenwand (46, 47) der Haube (42) aufweist, daß die Ionisierungsvorrichtung wenigstens eine Gegenelektrode (55, 56) aufweist, daß die Gegenelektrode (95, 96) an Masse liegt, daß die Ionisierungsvorrichtung mit einer Hochspannung von vorzugsweise 5 bis 25 kV beaufschlagt ist, daß die Hochspannung gepulst ist und die Impulse eine Impulsdauer von vorzugsweise 1 bis 100 ms aufweisen, und daß das Tastverhältnis der Hochspannungsimpulse in einem Bereich von vorzugsweise 1:8 bis 1:12 liegt.

17. Anlage nach einem der vorhergehenden Ansprüche, **dadurch gekennzeichnet**, daß wenigstens eine Meßsonde zur Überwachung der Gaskonzentration, der Gasgemisch-Anteile und/oder des Gas- bzw. Gasgemischgehalts in einem Dampfbereich vorgesehen ist, und daß die von der Meßsonde ermittelten Meßwerte vorzugsweise zur Steuerung bzw. Regelung der Gaskonzentration, der Gasgemisch-Anteile und/oder des Gas- bzw. Gasgemischgehalts im Dampfbereich herangezogen werden.

18. Anlage nach einem der vorhergehenden Ansprüche, **dadurch gekennzeichnet**, daß in einer Leitung, über die Behandlungsfluid abfließt, ein Flowmeter zur Ermittlung der Durchflußmenge des Behandlungsfluids vorgesehen ist, die vom Flowmeter ermittelten Meßwerte vorzugsweise zur Steuerung bzw. Regelung der ein- und/oder ausströmenden Fluidmenge herangezogen werden, wobei die Steuerung bzw. Regelung der ein- und/oder ausströmenden Fluidmenge mittels eines Ventils, insbesondere eines mit einem Motor getriebenen Ventils erfolgt.

19. Anlage nach einem der vorhergehenden Ansprüche, **dadurch gekennzeichnet**, daß ein aus dem Behälter ausströmendes Fluid in einer Wiederaufbereitungsanlage wiederaufbereitet wird, daß das wiederaufbereitete Fluid im Behälter wiederverwendet wird, und/oder daß das wiederaufbereitete Fluid wenigstens teilweise der Brauchwasserableitung zugeführt wird.

20. Trocknungsverfahren zum Trocknen von Substraten (25) in einem ein Behandlungsfluid (23) enthaltenden Behälter (21), mit einer Aushubvorrichtung (1) zum Ein- und Ausbringen wenigstens eines Substratträgers (17) und der Substrate (25), wobei die Aushubvorrichtung (1) einen ersten Transportschlitten (2) für eine Substratanhebevorrichtung (16) und einen zweiten Transportschlitten (3) für den Substratträger-Halter aufweist,die über eine Gelenkverbindung (4) miteinander verbunden sind, gekennzeichnet durch folgende Verfahrensschritte:
- Ausheben der Substrate (5) aus einem Spülfluid (23) und Belassen des Subtratträgers (17) im Behälter (21);
- Absenken des Spülfluids (23) unter den Substratträger (17); und
- Absenken der Substrate (25) in den Substrat-träger (17) nach dem Trocknungsvorgang.

## Claims

1. Plant (20) for chemical wet-treatment of substrates (25) in a container (21) containing a treatment fluid (23), with a lifting-out device (1) for taking in and out at least one substrate carrier (17) and the substrate (25), wherein the lifting-out device (1) comprises a first transport carriage (2) for a substrate raising device (16) and a second transport carriage (3) for a substrate carrier holder, **characterised in that** the two transport carriages (2, 3) are connected together by an articulated connection (4).

2. Installation (20) according to claim 1, **characterised in that** the first and the second transport carriage (2, 3) is movable on a vertical guide rail (10) and that the first transport carriage (2) is preferably connected with a drive device.

3. Installation (20) according to one of the preceding claims, **characterised in that** the articulated connection (4) comprises two arms (5, 6), wherein a first arm (5) is pivotably connected with the first transport carriage (2) and a second arm (6) is pivotably connected with the second transport carriage (3), and the ends of the first and second arms (5, 6) remote from the transport carriages (2, 3) are rotatably connected together by way of a pin (7).

4. Installation (20) according to claim 3, **characterised in that** a protruding region of the pin connecting the two arms (5, 6) runs on a control cam (11).

5. Installation (20) according to claim 4, **characterised in that** the control cam (11) comprises a straight portion (12) extending parallel to the movement direction of the transport carriages (2, 3) and a curved portion (13) connected to the straight portion, that the spacing between the first and second transport carriages (2, 3) is constant when the pin (7) runs on the straight portion (12), that the spacing between the first and second transport carriages (2, 3) increases when the pin (7) runs on the curved portion (13), that the shape of the curved portion (13) is preferably so selected that the spacing between the first and second transport carriages (2, 3) constantly increases and that the shape of the curved portion (13) in its end region is preferably so selected that the second transport carriage (3) comes to a stop gradually.

6. Installation (20) according to one of claims 4 and 5, **characterised in that** the first transport carriage (2) is connected with a knife-like raising device (16), that the knife-like raising device (16) and the substrate carrier (17) are raised at the same speed when the pin (7) runs on the straight portion (12) of the control cam (11), that the second transport carriage (3) comes to a stop when the substrates (25) come into engagement in guides (39) outside the substrate carrier (17) and that the guides are preferably constructed in a hood (22) above the container (21).

7. Installation (20) according to claim 6, **characterised in that** the lifting-out of the substrate (25) after stopping of the second transport carriage (3) is effected by the knife-like raising device (16).

8. Installation (20) according to one of the preceding claims, **characterised in that** the installation (20) is provided for washing and/or drying of substrates (20).

9. Installation (20) according to one of the preceding claims, characterised by a gas inlet device for loading the substrate and/or the substrate carrier with a gas during the drying process, especially a gas mixture of isopropylalcohol and nitrogen.

10. Installation (20) according to one of the preceding claims, **characterised in that** in addition a releasable and lockable latching mechanism is provided, which rigidly connects the first and second transport carriages (2, 3) together, and that preferably a cylinder is provided, which unlocks and/or locks the latching mechanism.

11. Installation according to one of the preceding claims, **characterised in that** a closable hood (42) is provided above the container (48), the hood (42) comprises a drip protection device (43, 61) and that the drip protection device is a draining plate (43) and is preferably arranged on the upper side of the hood (42).

12. Installation according to one of the preceding claims, **characterised in that** a displaceable hood (42) is provided above the container (48) and comprises a drip protection device (43, 61), which is arranged as a collar (61) around the hood (42).

13. Plant according to claims 11 to 12, **characterised in that** the draining plate (43) or 5 the collar (61) protrudes out beyond the hood (42), that the draining plate (43) or the collar (61) preferably points obliquely downwardly at that side (45) of the hood (42) into which the hood (42) is displaced on opening of the container (48), and that a tank edge draining chute (49) is preferably provided above the edge (50) of the container (58), beyond which the hood (42) is not displaced.

14. Plant according to one of the preceding claims, **characterised in that** the container (71) has a cleaning opening (73), that the cleaning opening (73) is closed by at least one flange (74, 76), and that the cleaning opening (73) is provided at one side (72) of the container (71) preferably at or near the tank base.

15. Plant according to one of the preceding claims, **characterised in that** an ionisation device is provided above the container (48) in a or the hood (42) mentioned in claims 11 to 13.

16. Plant according to claim 15, **characterised in that** the ionisation device is provided in a vapour region in which the substrate, which is moved out of the container, is placed in a or the gas mentioned in claim 9, preferably nitrogen and/or isopropylalcohol, that the ionisation device comprises at least one ionising rod (91, 92) at at least one inner wall (46, 47) of the hood (42), that the ionisation device comprises at least one counter-electrode (55, 56), that the counter-electrode (95, 96) lies at ground, that the ionisation device is loaded with a high voltage of preferably 5 to 25 kV, that the high voltage is pulsed and the pulses have a pulse duration of preferably 1 to 100 ms, and that the keying ratio of the high voltage pulse lies in a range of preferably 1:8 to 1:12.

17. Plant according to one of the preceding claims, **characterised in that** at least one measuring probe for monitoring the gas concentration, the gas mixture proportions and/or the gas or gas-mixture content is provided in a vapour region, and that the measurement values ascertained by the measuring probe are preferably utilised for control or regulation of the gas concentration, the gas mixture proportions and/or the gas or gas-mixture content in the vapour region.

18. Plant according to one of the preceding claims, **characterised in that** a flow meter for ascertaining the throughflow quantity of the treatment fluid is provided in a duct by way of which the treatment fluid flows away and the measurement values ascertained by the flow meter are preferably utilised for control or regulation of the inflowing and/or outflowing flow quantity, wherein the control or regulation of the inflowing and/or outflowing fluid quantity is carried out by means of a valve, especially a valve operated by a motor.

19. Plant according to one of the preceding claims, **characterised in that** a fluid flowing out of the container is reprocessed in a reprocessing installation, that the reprocessed fluid is reused in the container and/or that the reprocessed fluid at least in part is fed to the service water discharge.

20. Drying method for drying substrates (25) in a container (21) containing a treatment fluid (23), with a lifting-out device (1) for bringing in and bringing out at least one substrate carrier (17) and the substrate (25); wherein the lifting-out device (1) comprises a first transport carriage (2) for a substrate raising device (16) and a second transport carriage (3) for the substrate carrier holder, which are connected together by way of an articulated connection (4), characterised by the following method steps:
- lifting of the substrate (5) out of a washing fluid (23) and leaving the substrate carrier (17) in the container (21);
- lowering the washing fluid (23) below the substrate carrier (17); and
- lowering the substrate (25) in the substrate carrier (17) after the drying process.

## Revendications

1. Installation (20) pour le traitement chimique par voie humide de substrats (25) dans un récipient (21) contenant un fluide de traitement (23), avec un dispositif d'enlèvement (1) pour introduire et sortir au moins un support de substrats (17) et les substrats (25), où le dispositif d'enlèvement (1) présente un premier chariot de transport (2) pour un dispositif de relevage de substrats (16) et un second chariot de transport (3) pour un organe de retenue de support de substrats, **caractérisée en ce que** les deux chariots de transport (2, 3) sont reliées entre eux par une liaison d'articulation (4).

2. Installation (20) selon la revendication 1, **caractérisée en ce que** le premier et le second chariot de transport (2, 3) sont déplaçables sur un rail de guidage vertical (10), et en ce que le premier chariot de transport (2) est relié de préférence à un dispositif d'entraînement.

3. Installation (20) selon l'une des revendications précédentes, **caractérisée en ce que** la liaison d'articulation (4) présente deux branches (5, 6), où une première branche (5) est reliée d'une manière articulée au premier chariot de transport (2) et une seconde branche (6) ou second chariot de transport (3), et en ce que les extrémités des première et seconde branches (5, 6) éloignées des chariots de transport (2, 3) sont reliées l'une à l'autre d'une manière tournante par une tige (7).

4. Installation (20) selon la revendication 3, **caractérisée en ce qu**'une zone saillante de la tige reliant les deux branches (5, 6) roule sur une came (11).

5. Installation (20) selon la revendication 4, **caractérisée en ce que** la came (11) présente une section rectiligne (12), s'étendant parallèlement à la direction de déplacement des chariots de transport (2, 3) et une section courbée (13) faisant suite à la section droite, en ce que l'écart entre les premier et second chariots de transport (2, 3) est constant lorsque la tige (7) roule sur la section rectiligne, en ce que l'écart entre les premier et second chariots de transport (2, 3) s'agrandit lorsque la tige (7) roule sur la section courbée (3), de telle sorte que la forme de la section courbée (13) est choisie de préférence de façon que l'écart entre les premier et second chariots de transport (2, 3) s'agrandit continuellement, et en ce que la forme de la section courbée (13) est sélectionnée dans sa zone d'extrémité de préférence de façon que le deuxième chariot de transport (3) s'arrête progressivement.

6. Installation (20) selon l'une des revendications 4 ou 5, **caractérisée en ce que** le premier chariot de transport (2) est relié à un dispositif de relevage (16) semblable à un couteau, en ce que le dispositif de relevage (16) semblable à un couteau et le support de substrats (17) sont relevés à la même vitesse lorsque la tige (7) roule sur la section rectiligne (12) de la came (11), en ce que le second chariot de transport (3) s'arrête lorsque les substrats (25) viennent en prise avec des guidages (39) à l'extérieur du support de substrats (17), et en ce que les guidages sont réalisés de préférence dans un capot (22) au-dessus du récipient (21).

7. Installation (20) selon la revendication 6, **caractérisée en ce que** la sortie des substrats (25) a lieu après l'arrêt du second chariot de transport (3) par le dispositif de relevage (16) semblable à un couteau.

8. Installation (20) selon l'une des revendications précédentes, **caractérisée en ce que** l'installation (20) est prévue pour le rinçage et/ou le séchage de substrats (25).

9. Installation (20) selon l'une des revendications précédentes, caractérisée par un dispositif d'admission de gaz pour charger les substrats et/ou le support de substrats pendant l'opération de séchage avec un gaz, notamment un mélange de gaz d'alcool isopropylique et d'azote.

10. Installation (20) selon l'une des revendication précédentes, **caractérisée en ce qu**'il est prévu de plus un mécanisme d'enclenchement pouvant être relâché et arrêté qui relie les premier et second chariots de transport (2, 3) rigidement l'un à l'autre, et en ce qu'il est prévu de préférence un vérin qui déverrouille et/ou verrouille le mécanisme d'enclenchement.

11. Installation selon l'une des revendications précédentes, **caractérisée en ce qu**'il est prévu un capot déplaçable (42) sur le récipient (48), et en ce que le capot (42) présente un dispositif de protection contre des gouttes (43, 61), en ce que le dispositif de protection contre les gouttes est un égouttoir (43) et est disposé de préférence sur le côté supérieur du capot (42).

12. Installation selon l'une des revendications précédentes, **caractérisée en ce qu**'il est prévu un capot déplaçable (42) sur le récipient (48) qui présente un dispositif de protection contre les gouttes (43, 61) qui est disposé comme col (61) autour du capot (42).

13. Installation selon la revendication 11 à 12, **caractérisée en ce que** l'égouttoir (43) respectivement le col (61) fait saillie sur le capot (42), en ce que l'égouttoir (43), respectivement le col (61) est incliné de préférence vers le côté (45) du capot (42) en biais vers le bas, vers lequel le capot (42) lors de l'ouverture du récipient (48), est déplacé, et en ce qu'il est prévu au-dessus du bord (50) du récipient (58) sur lequel le capot (42) n'est pas déplacé, de préférence un biais d'égouttement (49) de bord de bassin.

14. Installation selon l'une des revendications précédentes, **caractérisée en ce que** le récipient (71) présente une ouverture de nettoyage (73), en ce que l'ouverture de nettoyage (73) est fermée par au moins une bride (74, 76), et en ce que l'ouverture de nettoyage (73) est prévue sur un côté (72) du récipient (71), de préférence au ou à proximité du fond du bassin.

15. Installation selon l'une des revendications précédentes, **caractérisée en ce qu**'il est prévu un dispositif d'ionisation dans un respectivement le capot (42) mentionné dans les revendications 11 à 13 au-dessus du récipient (48).

16. Installation selon la revendication 15, **caractérisée en ce que** le dispositif d'ionisation est prévu dans une zone de vapeur dans laquelle le substrat sorti du récipient est exposé à un respectivement le gaz mentionné dans la revendication 9, de préférence à de l'azote et/ou à l'alcool isopropylique, en ce que le dispositif d'ionisation présente au moins un bâtonnet d'ionisation (91, 92) à au moins une paroi intérieure (46, 47) du capot (42), en ce que le dispositif d'ionisation présente au moins une contre-électrode (55, 56), en ce que la contre-électrode (95, 96) est reliée à la masse, en ce que le dispositif d'ionisation est chargé en une haute tension de préférence de 5 à 25 kV, en ce que la haute tension est pulsée et que les impulsions ont une durée d'impulsion de préférence de 1 à 100 ms, et en ce que le taux d'impulsions des impulsions haute tension se situe dans une plage de préférence de 1 :8 à 1 :12.

17. Installation selon l'une des revendications précédentes, **caractérisée en ce qu**'il est prévu au moins une sonde de mesure pour surveiller la concentration du gaz, les parts de mélange de gaz et/ou de la proportion de gaz respectivement de mélange de gaz dans une zone de vapeur, et en ce que les valeurs de mesure détectées par la sonde de mesure sont utilisées de préférence pour la commande respectivement le réglage de la concentration du gaz, des parts de mélange de gaz et/ou de la proportion du gaz respectivement du mélange de gaz dans la zone de vapeur.

18. Installation selon l'une des revendications précédentes, **caractérisée en ce qu**'il est prévu dans une conduite, par laquelle s'écoule le fluide de traitement, un débitmètre pour détecter la quantité d'écoulement du fluide de traitement, en ce que les valeurs de mesure détectées par le débitmètre sont utilisées de préférence pour la commande respectivement le réglage de la quantité de fluide affluant et/ou effluent, où la commande respectivement le réglage de la quantité de fluide affluant et/ou effluent a lieu au moyen d'une vanne, notamment d'une vanne entraînée par un moteur.

19. Installation selon l'une des revendications précédentes, **caractérisée en ce qu**'un fluide s'écoulant du récipient est retraité dans une installation de retraitement, en ce que le fluide retraité est réutilisé dans le récipient et/ou en ce que le fluide retraité est amené au moins partiellement à la conduite des eaux industrielles.

20. Procédé de séchage pour le séchage de substrats (25) dans un récipient (21) contenant un fluide de traitement (23), avec un dispositif d'enlèvement (1) pour introduire et sortir au moins un support de substrats (17) et les substrats (25), où le dispositif d'enlèvement (1) présente un premier chariot de transport (2) pour un dispositif de relevage de substrats (16) et un second chariot de transport (3) pour l'organe de retenue de support de substrats, qui sont reliés l'un à l'autre par une liaison d'articulation (4), caractérisé par les étapes de procédé suivantes:
- sortir les substrats (5) d'un fluide de rinçage (23) et laisser le support de substrats (17) dans le récipient (21);
- baisser le fluide de rinçage (23) sous le support de substrats (17) ; et
- abaisser les substrats (25) dans le support de substrats (17) après l'opération de séchage.
